# FASCICULE DE BREVET EUROPEEN

(11) **EP 0 875 903 B1**
(45) Date de publication et mention de la délivrance du brevet: **28.06.2000**
(21) Numéro de dépôt: 98401040.5
(22) Date de dépôt: 28.04.1998
(51) Int. Cl.: G11C 17/16

(54) **Procédé de commande d'une cellule mémoire et mémoire non volatile programmable une seule fois en technologie CMOS**
Steuerverfahren für eine Speicherzelle mit nur einmal programmierbarem nicht flüchtigen CMOS-Speicher
Control method for memory cell and CMOS non volatile programmable memory

(30) Priorité: 29.04.1997 FR 9705300
(43) Date de publication de la demande: 04.11.1998
(73) Titulaire: STMicroelectronics S.A., 94250 Gentilly (FR)
(72) Inventeur: Fournel, Richard, 94230 Cachan (FR); Marinet, Fabrice, 94230 Cachan (FR)
(74) Mandataire: Ballot, Paul

(56) Documents cités:
- EP-A- 0 510 667
- DE-A- 4 300 703
- TOSHITAKA FUKUSHIMA ET AL: "A 15-ns 8-kbit junction shorting registered PROM" IEEE JOURNAL OF SOLID-STATE CIRCUITS., vol. 21, no. 5, octobre 1986, NEW YORK US, pages 861-868, XP002052838

## Description

La présente invention concerne un procédé de commande d'une cellule mémoire et une mémoire non volatile programmable une seule fois en technologie CMOS.

Les mémoires non volatiles programmables une seule fois sont notamment utilisées pour contenir dés données de configuration dans un système électronique. Elles permettent ainsi de particulariser le circuit de manière irréversible, donc sûre. Il s'agit notamment des registres de configuration associés à un circuit microprocesseur.

Habituellement, ces mémoires sont obtenues à partir de mémoires classiques du type EPROM ou FLASH EPROM, que l'on a modifiées pour supprimer la fonction de reprogrammation. Les mémoires EPROM sont dans ce cas fournies sous boîtier (plastique) sans fenêtre. On ne peut donc effectuer l'effacement par rayons ultraviolets. Les flash EPROM sont modifiées pour n'accepter qu'une seule programmation (modification logicielle).

Ces mémoires présentent cependant l'inconvénient de nécessiter une technologie complexe comprenant de nombreuses étapes spécifiques supplémentaires par rapport aux technologies MOS ou CMOS courantes, notamment pour réaliser les grilles flottantes, avec des procédures de test également plus complexes.

Les mémoires de ce type sont donc assez coûteuses.

Dans l'invention, on a cherché une nouvelle structure de cellule mémoire non volatile programmable une seule fois, réalisable en utilisant une technologie CMOS courante, non spécifique.

Dans l'invention, on a cherché une nouvelle structure de cellule mémoire de faible encombrement, programmable au moyen d'une tension de l'ordre de la tension d'alimentation admise par le circuit intégré.

La demande EP 94 402 529.5 (EP-A-0 655 783) de la Demanderesse ayant pour titre "Fusible pour circuit intégré" décrit un fusible particulier comprenant une jonction semi-conductrice et un transistor MOS de type N apte à fournir une densité de courant importante à l'endroit du contact métallique réalisé sur cette jonction. Le métal du contact se diffuse dans la jonction, dormant des filaments de métal qui court-circuitent la jonction. Pour obtenir cet effet de diffusion, le transistor polarise la jonction en direct et il est dimensionné pour fournir la densité de courant nécessaire (milliampère/micromètre carré à l'endroit du contact) vers la jonction. Il est donc assez gros. En plus de ce transistor T1 de claquage, une circuiterie de lecture connectée à la jonction est prévue, à polarisation directe ou inverse, en tension ou en courant.

Le principe du fusible décrit dans cette demande est intéressant en ce qu'il utilise un procédé classique CMOS (pas de grille flottante en particulier) et qu'il ne nécessite pas de haute tension de programmation. Cependant le dispositif de claquage et de lecture proposé autour de ce fusible apparaît particulièrement encombrant et n'offre pas un accès matriciel au fusible. Il est donc peu propice à une utilisation comme cellule mémoire.

Un objet de l'invention est de proposer une cellule mémoire utilisant le principe de claquage décrit dans la demande précitée, mais avec des moyens adaptés à une utilisation matricielle dans une mémoire.

Un autre objet de l'invention est de proposer une cellule mémoire d'encombrement très faible.

Un autre objet de l'invention est de proposer une cellule mémoire programmable au moyen d'un niveau de tension de l'ordre de la tension d'alimentation.

La solution à ce problème technique a été trouvée dans l'invention en utilisant comme cellule mémoire un transistor de faible dimension en série avec une jonction semi-conductrice, et des moyens de claquage apte à polariser ledit transistor en mode de conduction bipolaire (Snap-back en littérature anglo-saxonne). On connaît du document DE-A-4 300 703 l'utilisation d'un transistor en mode bipolaire pour réduire la résistance d'un diélectrique. Dans l'invention, on utilise ce mode bipolaire pour fournir la densité de courant nécessaire au claquage. En mode de lecture, une polarisation de la cellule mémoire avec la jonction polarisée en direct ou en inverse offre une détection tout aussi fiable.

Telle que caractérisée, l'invention concerne donc un procédé de commande d'une cellule mémoire dans un circuit intégré en technologie CMOS, ladite cellule comportant en série un transistor MOS de sélection de type N et une jonction semi-conductrice PN, la source du transistor étant reliée à la zone P de la jonction au moyen d'un contact métallique réalisé sur une partie au moins de ladite zone P.

Selon l'invention, le procédé de commande consiste en programmation à appliquer au circuit intégré un niveau de tension d'alimentation supérieur à une valeur nominale, dans une limite supérieure admissible pour le circuit intégré, à appliquer ce niveau sur le drain et la grille du transistor de sélection, ledit transistor de sélection étant réalisé avec un canal ayant une longueur inférieure ou égale à la longueur minimum de la technologie CMOS considérée, de manière à polariser ledit transistor de sélection en mode de conduction bipolaire.

L'invention concerne aussi une mémoire correspondante.

D'autres caractéristiques et avantages de l'invention sont présentés dans la description suivante faite à titre indicatif et non limitatif et en référence aux dessins annexés, dans lesquels :
- les figures 1a et 1b montrent la structure d'une cellule mémoire selon l'invention, sur substrat semi-conducteur respectivement de type P (fig.1a) et de type N (fig.1b) et la figure 1c, le schéma électrique correspondant;
- la figure 2 rappelle l'allure générale de caractéristique courant/tension de conduction bipolaire pour un transistor MOS ;
- la figure 3 montre la polarisation en inverse d'une cellule mémoire en mode de lecture;
- la figure 4 montre les courbes courant/tension de ligne de bit pour une détection en inverse, pour une cellule mémoire programmée et une cellule mémoire non programmée;
- la figure 5 montre la polarisation en direct d'une cellule en mode de lecture;
- la figure 6 montre les courbes courant/tension de ligne de bit pour une détection en inverse, pour une cellule mémoire programmée et une cellule mémoire non programmée;
- la figure 7 montre un schéma global d'une structure d'une mémoire selon l'invention et
- la figure 8 est un tableau récapitulatif des polarisations applicables.

Une cellule mémoire selon l'invention est représentée sur la figure la, pour un substrat semi-conducteur de type P. Elle comprend un transistor MOS de type N T1 en série avec une jonction semi-conductrice PN, J1.

Cette jonction est formée d'une zone 1 de diffusion de type P réalisée dans un caisson 2 de type N opposé au substrat. Un contact métallique 3 est formé sur la zone 1 de diffusion.

Une prise de caisson 4 est enfin prévue, pour relier le caisson à une ligne de connexion commune NP du plan mémoire.

Comme expliqué de manière détaillée dans la demande EP 94 402529-5 (EP-A-0 655 783), la zone 1 est peu profonde, de quelques dixième de micromètre environ. Le contact métal est réalisé en aluminium selon les technologies classiques CMOS, mais du cuivre ou d'autres métaux ayant des propriétés similaires pourraient tout aussi bien être utilisés.

C'est le transistor MOS qui permet l'accès matriciel à la cellule mémoire. La grille g du transistor MOS est reliée à une ligne de mot WL du plan mémoire et le drain du transistor est relié à une ligne de bit BL du plan mémoire. La source s du transistor est reliée à la zone N de la jonction PN par le contact métallique 3.

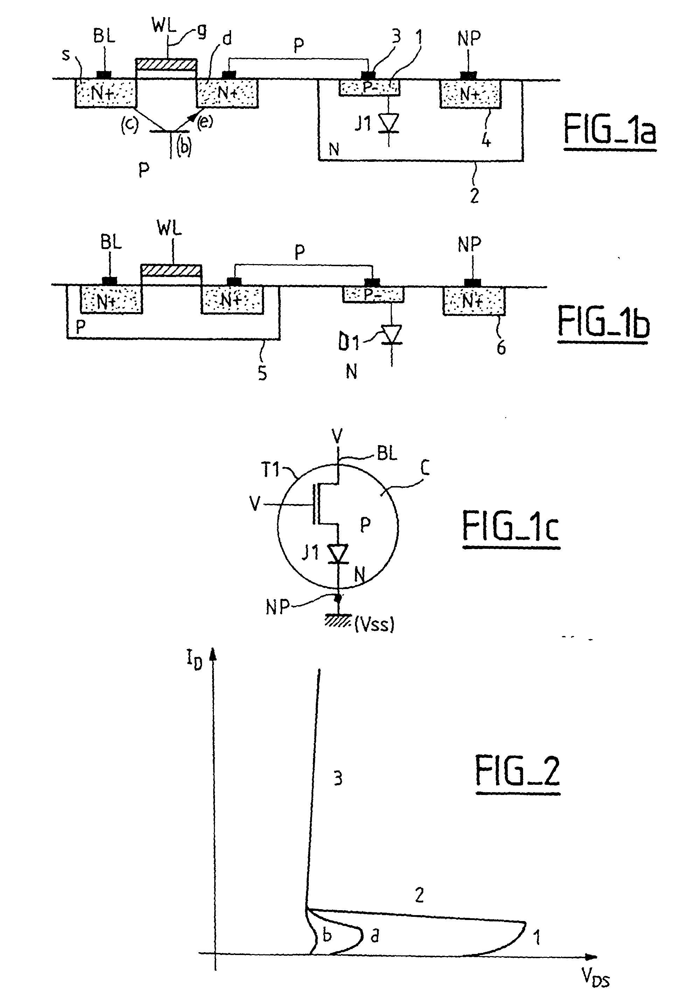

Une réalisation de cette cellule mémoire dans la technologie duale sur substrat semi-conducteur de type N est représentée sur la figure 1b. C'est alors le transistor MOS qui est réalisé dans un caisson 5 de type P, alors que la zone de diffusion de jonction est réalisée directement dans le substrat, une prise de substrat 6 fournissant la connexion de la cellule mémoire à la ligne de connexion commune NP du plan mémoire.

Le schéma électrique correspondant à la cellule mémoire selon l'invention est représenté sur la figure 1c. On a ainsi une cellule mémoire C qui comprend un transistor de sélection MOS de type N, T1, en série avec une jonction semi-conductrice J1. Le drain du transistor T1 est relié à une ligne de bit BL, la grille à une ligne de mot WL et la source à la zone P (anode) de la jonction J1. La zone N de la jonction (cathode) est reliée à un noeud NP, commun à toutes les cellules d'un plan mémoire.

Pour programmer la cellule C, on prévoit d'appliquer sur la ligne de bit LB et sur la ligne de mot WL la tension d'alimentation Vdd, tandis que le noeud NP est mis à la masse (Vss). Il s'agit en effet de faire conduire un courant important par le transistor T1 pour obtenir le court-circuit de la jonction J1 par diffusion du métal du contact 3 (Figure 1a).

Comme enseigné dans la demande européenne précitée, on peut avoir un transistor T1 très large pour conduire le courant demandé.

Selon l'invention, on préfère utiliser un transistor à canal court, en combinaison avec l'application comme niveau de tension d'alimentation Vdd, d'un niveau supérieur au niveau nominal de la tension d'alimentation, dans une limite supérieure admissible par le circuit intégré, pour obtenir le mode de conduction bipolaire du transistor MOS. Ce mode correspond, comme cela est bien connu, au déclenchement prédominant sur le fonctionnement MOS du transistor bipolaire latéral parasite inhérent à la structure. Le transistor bipolaire parasite latéral est représenté schématiquement sur la figure 1a. Avec un tel mode, on a un gain en courant très élevé dans la base, et le transistor T1 peut conduire le courant nécessaire pour claquer la jonction selon l'invention. Pour mémoire, l'allure générale de la caractéristique de conduction bipolaire est représentée sur la figure 2. Quand la tension drain-source atteint la tension de claquage Bvds, la jonction drain-substrat passe en avalanche (zone 1 de la caractéristique). Cela entraîne la polarisation de la jonction source-substrat. Le courant augmente dans la base, déclenchant le mode de conduction bipolaire (zone 3), dans lequel le gain en courant est très élevé et la résistance série du transistor très faible. Plus la tension de grille du transistor est élevée, plus la tension de claquage Bvds diminue, comme montré par les courbes a et b. A l'extrême, on se retrouve presque instantanément en mode de conduction bipolaire. Par ailleurs, plus la longueur du canal du transistor est courte, plus le gain en courant dans la base est élevé, favorisant le passage en conduction bipolaire. Ce sont ces différents principes qui sont utilisés dans l'invention pour obtenir la programmation de la cellule mémoire avec une tension de l'ordre de la tension d'alimentation nominale du circuit intégré: tension de grille à Vdd et canal court. Par exemple, dans une technologie HCMOS5, on aura une géométrie W/L du transistor T1 de l'ordre de 10 microns /0.5 microns. La longueur L (0,5 microns) du canal du transistor T1 est dans cet exemple la longueur minimum définie par la technologie. Le niveau de tension pour la programmation sera alors typiquement de l'ordre de 6,5 volts pour une tension d'alimentation Vdd nominale de 5 volts. On a en effet une tolérance entre 4 et 6.5 volts en général pour la tension d'alimentation du circuit intégré.

Pour des niveaux de tension d'alimentation Vdd inférieurs à 5 volts en nominal, il faut prévoir une longueur de canal inférieure à la longueur minimum définie pour la technologie, pour être certain de polariser le transistor MOS T1 en mode de conduction bipolaire. En effet, ce mode s'active pour une tension de grille d'autant plus faible que le canal du transistor est court (gain en courant d'autant plus élevé). Ceci ne pose pas de problèmes d'étapes technologiques supplémentaires, mais seulement une adaptation des masques de fabrication, ce qui se fait aisément.

Après le claquage, la jonction J1 est équivalente à une très faible résistance en série avec le transistor T1.

En pratique, on prévoit en programmation des moyens de limitation du courant de programmation, pour empêcher la destruction du transistor. Ces moyens sont par exemple une résistance de limitation qui peut être placée en série sur la zone N de la jonction.

Pour une mémoire en circuit intégré utilisant une telle cellule mémoire, l'utilisateur qui veut programmer la cellule prévoit ainsi d'appliquer, le temps de la programmation, soit pendant quelques secondes, un niveau de tension d'alimentation Vdd un peu plus élevé. Ceci se fait sans risque pour le circuit intégré, puisque ce niveau de programmation reste dans le gabarit admissible par le circuit.

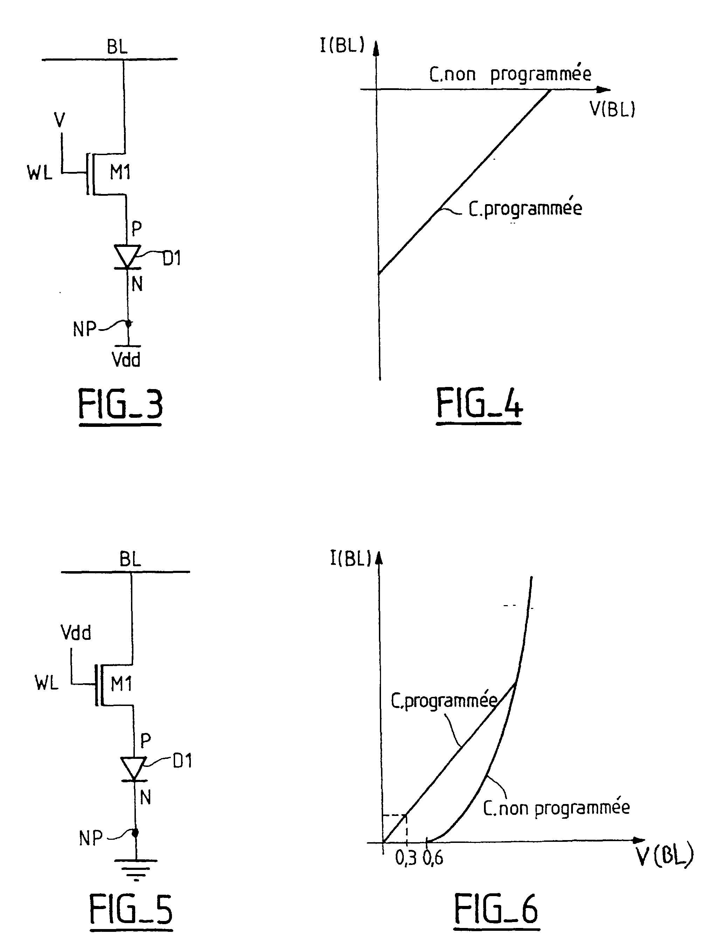

S'agissant de lire une telle cellule mémoire, deux possibilités sont offertes. Dans la première, on utilise un mode de polarisation inverse de la jonction (figures 3 et 4). Dans la seconde on utilise un mode de polarisation directe de la jonction (figures 5 et 6).

Les figures 3 et 4 montrent le principe de lecture d'une cellule mémoire selon l'invention, dans un mode de polarisation inverse.

Dans ce mode, on applique à la cellule sélectionnée en lecture le niveau nominal de la tension d'alimentation Vdd, à la fois sur la grille et sur la ligne commune NP. La ligne de bit n'est pas chargée initialement. Elle est donc à zéro volt. Si la jonction n'est pas claquée, elle est équivalente à un circuit ouvert. La ligne de bit reste à zéro volt. Si la jonction est claquée, elle est équivalente à une faible résistance. Le transistor T1 va alors conduire et la ligne de bit BL monte à un niveau proche de Vdd. On a donc un courant qui circule sur la ligne de bit.

En plaçant sur la ligne de bit, un circuit de détection en courant ou en tension, on obtient en sortie un niveau binaire 0 ou 1 correspondant à l'état non programmé ou programmé de la cellule.

La figure 4 montre la courbe I(BL)=fn V(BL) pour une cellule non programmée et une cellule programmée selon ce mode de lecture. La détection est aisée et permet d'utiliser des amplificateurs de lecture classiques.

Un autre principe de lecture est applicable, comme représenté sur les figures 5 et 6. Dans ce cas, la cellule est polarisée en direct. On applique la tension d'alimentation Vdd sur la ligne de mot WL et la masse sur la ligne commune NP. Par ailleurs, on précharge ou on positionne la ligne de bit à une tension d'un niveau inférieur au seuil de jonction (0,6 volt). Par exemple on polarise la ligne de bit à 0,3 volt.

Si la jonction n'est pas claquée, elle est équivalente à un circuit ouvert. La ligne de bit reste à 0,3 volt. Si la jonction est claquée, elle est équivalente à une faible résistance. On peut détecter un courant sur la ligne de bit. En plaçant un convertisseur courant-tension sur la ligne de bit, on peut détecter l'état de la cellule mémoire. Compte-tenu des niveaux faibles de tension à détecter, il faut prévoir une circuiterie de lecture plus fine, notamment avec des miroirs de courant dans l'esprit des circuits décrits dans la demande européenne précitée.

Quel que soit le mode de lecture choisi (direct ou inverse), la cellule décrite permet un accès matriciel qui la rend compatible avec une utilisation dans un circuit mémoire.

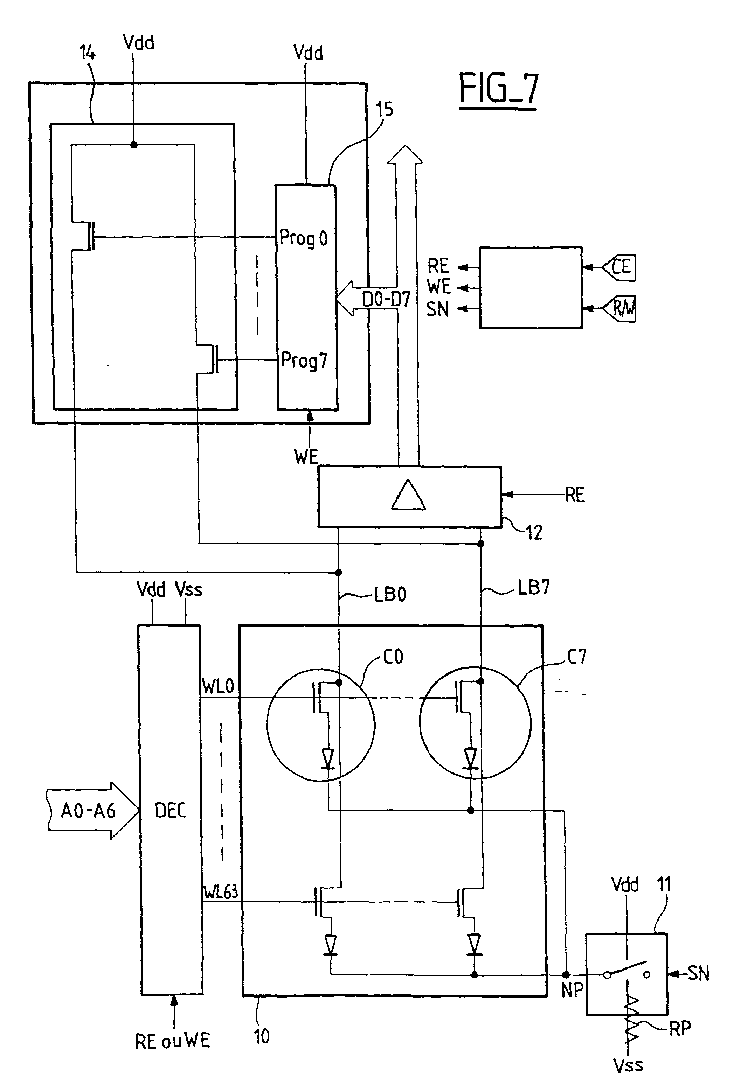

Un exemple d'architecture mémoire selon l'invention est représenté schématiquement sur la figure 7, en retenant la polarisation inverse en lecture.

Le plan mémoire comprend un ensemble de cellules mémoires, chacune à une intersection d'une ligne de bit et d'une ligne de mot. Chaque cellule mémoire est constituée d'un transistor de sélection MOS de type N en série avec une jonction semi-conductrice PN, selon la structure précédemment décrite en relation avec les figures 1.a à 1.c.

Les lignes de mot sont connectées aux grilles des transistors de sélection tandis que les lignes de bit sont connectées aux drains des transistors de sélection.

Les zones N des jonctions des cellules mémoires sont reliées à une ligne NP, commune à tout le plan mémoire dans l'exemple.

Pour la simplicité de l'exposé, la figure 7 représente une structure très simple avec accès en lecture par mot de 8 bits. L'invention ne se limite évidemment pas à ce type de structure. L'homme du métier saura l'adapter aux facilités d'accès qu'il souhaite ou encore à la capacité mémoire envisagée.

Dans l'exemple, un décodeur d'adresse DEC permet la sélection d'une parmi les lignes de mot WL0 à WL63 en fonction des signaux d'adresse A0-A6 qu'il reçoit. Quel que soit le mode d'accès, lecture ou écriture, il sélectionne cette ligne de mot en lui appliquant le niveau de tension d'alimentation Vdd, les autres lignes de mot étant mises à la masse. En programmation, le niveau Vdd est supérieur au niveau nominal de la tension d'alimentation, dans une limite admissible par le circuit intégré.

Un circuit de commande 11 de la ligne commune NP permet d'appliquer comme tension de polarisation, la tension Vdd ou la masse, selon l'état 0 ou 1 d'un signal de commande binaire noté SN.

Dans un exemple, si le signal SN est à "1", signifiant un accès en lecture (polarisation inverse), c'est Vdd qui est appliqué sur la ligne commune NP.

Si le signal SN est à "0", signifiant un accès en programmation, c'est la masse Vss qui est appliquée sur la ligne commune NP.

On notera ici que si on avait retenu le principe de polarisation directe en lecture, la ligne commune serait toujours à Vss, ne nécessitant aucun circuit de commande associé. Par contre , on a vu que la détection en lecture doit alors être plus fine.

Les lignes de bit LB0 à LB7 sont appliquées à la fois à un circuit de lecture 12 et un circuit d'écriture 13, un seul de ces circuits étant activé à un moment donné par des signaux de sélection appropriés, WE pour l'écriture, RE pour la lecture.

Le circuit de lecture 12 comprend des amplificateurs de lecture, un par ligne de bit, de structure adaptée au mode de polarisation en inverse tel que décrit précédemment. Il délivre une information logique 0 ou 1 correspondant à la donnée lue sur chaque ligne de donnée D0 à D7 correspondant aux lignes LB0 à LB7.

Pour lire un mot (octet) de la mémoire, on présente l'adresse de la ligne de mot sur les signaux d'adresse A0-A6, et on sélectionne la mémoire en lecture. Le décodeur mémorise l'adresse, la décode et sélectionne la ligne de mot correspondante en lui appliquant la tension d'alimentation Vdd.

Les cellules sélectionnées sont celles de la ligne de mot sélectionnée. Elles ont toutes leur grille à Vdd.

Toutes les autres cellules de la mémoire ont leur grille à Vss. Elles ne peuvent donc pas conduire. Le neutre NP est à Vdd pour toutes les cellules.

Le circuit de programmation 13 comprend un circuit porte 14 commandé par un circuit de commutation de tension 15.

Ce circuit 15 reçoit en entrée les signaux de donnée D0 à D7 qui indiquent, en programmation, l'octet à écrire, par exemple 10000001. L'adresse où écrire cet octet est présenté sur les signaux d'adresse A0-A6. Quand il est activé, le circuit 15 permet de commuter sur les sorties correspondant aux bits à programmer, dans l'exemple Prog0 et Prog7, le niveau Vdd d'alimentation et le niveau Vss sur les autres sorties, Prog1 à Prog6 dans l'exemple. Ces sorties Prog0 à Prog7 commandent les grilles des transistors portes du circuit 14.

Quand il est désactivé, le circuit 15 a toutes ses sorties Prog0 à Prog7 à 0 (Vss).

Le circuit 14 comprend un transistor porte par ligne de bit, connecté en série entre la tension d'alimentation Vdd et la ligne de mot associé. Quand un transistor porte reçoit sur sa grille le niveau vdd, il commute pratiquement sans pertes le niveau Vdd sur la ligne de bit associée. Si il reçoit 0 sur sa grille, la ligne de bit associée reste en état de haute impédance.

Ainsi, seules les cellules des lignes de bit sélectionnées au moyen du circuit 15 reçoivent la tension de programmation Vdd, sur le drain de leur transistor de sélection.

Parmi ces cellules, celles qui sont sur la ligne de mot sélectionnée ont la grille de leur transistor de sélection à Vdd également. Les autres cellules ont leur grille à zéro, ce qui les empêche de conduire.

Dans l'exemple, si c'est la ligne de mot WL0 qui est sélectionnée, seules les cellules C0 et C7 seront programmées. Les autres cellules ne sont pas affectées.

La cellule mémoire selon l'invention permet donc de réaliser une structure matricielle très fiable, et peu complexe.

De préférence, on prévoit des moyens pour limiter le courant conduit par le transistor de sélection. Ces moyens consistent par exemple en une résistance de limitation RP connectée en programmation à la ligne NP.

On rappelle que pour la programmation selon l'invention, la tension vdd est supérieure à sa valeur nominale.

Pour compléter la description, les signaux de sélection ou commande WE, RE et SN des différents circuits sont délivrés par un circuit 16 de type combinatoire qui reçoit classiquement un signal de sélection du circuit mémoire, noté CE actif bas en général et un signal de lecture/écriture R/W dont l'état binaire indique l'accès en lecture ou en écriture. Il fournit en sortie le signal de sélection d'écriture WE, le signal de sélection de lecture LE appliqué au circuit de lecture 12 pour l'activer en lecture seulement et le signal de commande binaire NS de la ligne commune NP, comme indiqué précédemment.

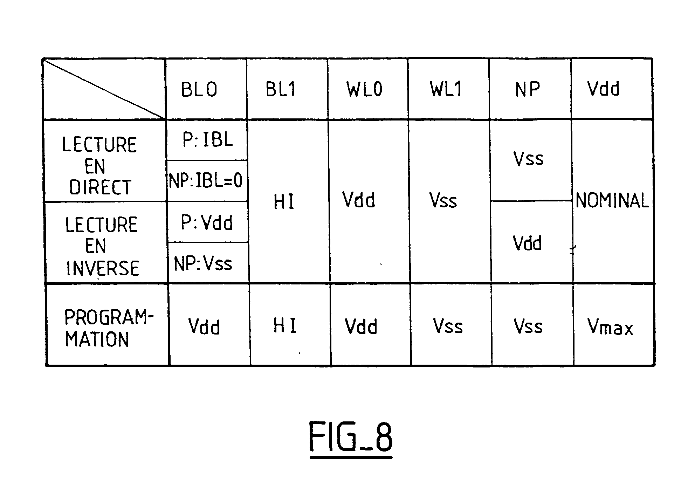

La figure 8 récapitule dans un tableau les polarisations applicables à une ligne de bit et une ligne de mot sélectionnées LB0 et WL0, aux lignes de bit et de mots non sélectionnées LB1 et WL1 et à la ligne commune NP du plan mémoire, pour les différentes commandes décrites.

## Revendications

1. Procédé de commande d'une cellule mémoire (C) dans un circuit intégré en technologie CMOS, ladite cellule (C) comportant en série un transistor MOS de sélection (T1,M1) de type N et une jonction semi-conductrice PN (J1,D1), la source du transistor (T1,M1) étant reliée à la zone P(1) de la jonction (J1,D1) au moyen d'un contact métallique (3) réalisé sur une partie au moins de ladite zone P(1), caractérisé en ce que le procédé de commande consiste en programmation à appliquer au circuit intégré un niveau de tension d'alimentation supérieur à une valeur nominale, dans une limite supérieure admissible pour le circuit intégré, à appliquer ce niveau sur le drain et la grille du transistor de sélection (T1,M1), ledit transistor de sélection (T1,M1) étant réalisé avec un canal ayant une longueur inférieure ou égale à la longueur minimum de la technologie CMOS considérée, de manière à polariser ledit transistor de sélection (T1,M1) en mode de conduction bipolaire.

2. Procédé de commande selon la revendication 1, caractérisé en ce qu'en programmation des moyens de limitation du courant de programmation sont prévus.

3. Procédé de commande selon la revendication 1 ou 2, caractérisé en ce qu'il consiste en lecture à appliquer la tension d'alimentation du circuit intégré sur la grille du transistor de sélection (T1,M1) et sur la zone N (4,6) de la jonction (J1,D1), pour détecter un niveau représentatif de l'état programmé ou non de la cellule (C) sur le drain de ladite cellule (C).

4. Procédé de commande selon la revendication 1 ou 2, caractérisé en ce qu'il consiste en lecture à appliquer la tension d'alimentation du circuit intégré sur la grille du transistor de sélection (T1,M1) et la masse sur la zone N (4,6) de la jonction (J1,D1), pour détecter sur le drain dudit transistor un niveau représentatif de l'état programmé ou non de la cellule (C), ledit drain étant polarisé à un niveau de tension inférieur à la tension de jonction polarisée en direct.

5. Mémoire en circuit intégré en technologie CMOS organisée matriciellement en lignes de bit (LB) et lignes de mot (WL), chaque cellule mémoire (C) comportant en série un transistor MOS de sélection (T1,M1) de type N et une jonction semi-conductrice PN (J1,D1), la source du transistor (T1,M1) étant reliée à la zone P(1) de la jonction (J1,D1) au moyen d'un contact métallique (3) réalisé sur une partie au moins de ladite zone P(1), le drain du transistor de sélection (T1,M1) étant relié à une ligne de bit (LB), la grille du transistor de sélection (T1,M1) étant reliée à une ligne de mot (WL) et la zone N de la jonction (J1,D1) étant reliée à une ligne commune NP, ladite mémoire comprenant des moyens de commande desdites cellule (C) pour réaliser les étapes du procédé selon l'une quelconque des revendications précédentes.

## Patentansprüche

1. Verfahren zur Steuerung einer Speicherzelle (C) in einer integrierten Schaltung der CMOS-Technologie, wobei die Zelle (C) in Serie einen MOS-Auswahltransistor des Typs N (T1, M1) und einen Halbleiterübergang PN (J1, D1) aufweist, wobei die Source des Transistors (T1, M1) mit der Zone P (1) des Übergangs (J1, D1) mittels eines metallischen Kontakts (3) verbunden ist, der mindestens in einem Teil der Zone P (1) hergestellt wurde, dadurch gekennzeichnet, daß das Steuerverfahren bei der Programmierung darin besteht, an die integrierte Schaltung einen Speisespannungspegel anzulegen, der höher ist als ein Nennwert, in einem für die integrierte Schaltung zulässigen oberen Grenzbereich, diesen Pegel an den Drain und das Gate des Auswahltransistors (T1, M1) anzulegen, wobei dieser Auswahitransistor (T1, M1) mit einem Kanal hergestellt ist, dessen Länge geringer als die oder gleich der Mindestlänge der betrachteten CMOS-Technologie ist, um den Auswahltransistor (T1, M1) im bipolaren Leitmodus vorzuspannen.

2. Steuerverfahren nach Anspruch 1, dadurch gekennzeichnet, daß bei der Programmierung Mittel zu Begrenzung des Programmierstroms vorgesehen sind.

3. Steuerverfahren nach Anspruch 1 oder 2, dadurch gekennzeichnet, daß es im Lesemodus darin besteht, die Speisespannung der integrierten Schaltung an das Gate des Auswahltransistors (T1, M1) und an die Zone N (4, 6) des Übergangs (J1, D1) anzulegen, um einen für den programmierten oder nichtprogrammierten Zustand der Zelle (C) repräsentativen Pegel am Drain dieser Zelle zu erfassen.

4. Steuerverfahren nach Anspruch 1 oder 2, dadurch gekennzeichnet, daß es im Lesebetrieb darin besteht, die Speisespannung der integrierten Schaltung an das Gate des Auswahltransistors (T1, M1) und die Masse an die Zone N (4, 6) des Übergangs (J1, D1) anzulegen, um am Drain des Transistors einen Pegel zu erfassen, der für den programmierten oder nichtprogrammierten Zustand der Zelle (C) repräsentativ ist, wobei der Drain auf einem Spannungspegel vorgespannt ist, der niedriger ist als die in Durchlaßrichtung vorgespannte Übergangsspannung.

5. Speicher in einer integrierten Schaltung der CMOS-Technologie, deren Matrix in Bitleitungen (LB) und Wortleitungen (WL) organisiert ist, wobei jede Speicherzelle (C) in Serie einen MOS-Auswahltransistor des Typs N (T, M1) und einen Halbleiterübergang PN (J1, D1) aufweist, wobei die Source des Transistors (T1, M1) mit der Zone P (1) des Übergangs (J1, D1) mittels eines metallischen Kontakts (3) verbunden ist, der in mindestens einem Teil der Zone P (1) hergestellt wurde, wobei der Drain des Auswahltransistors (T1, M1) mit einer Bitleitung (LB) verbunden ist, wobei das Gate des Auswahltransistors (T1, M1) mit einer Wortleitung (WL) und die Zone N des Übergangs (J1, D1) mit einer gemeinsamen Leitung NP verbunden ist, wobei der Speicher Mittel zur Steuerung der Zellen (C) aufweist, um die Schritte des Verfahrens nach einem beliebigen der vorhergehenden Ansprüche durchzuführen.

## Claims

1. Control method for a memory cell (C) in an integrated circuit in CMOS technology, the said cell (C) having in series an n-type MOS selection transistor (T1, M1) and a p-n semiconductor junction (J1, D1), the source of the transistor (T1, M1) being connected tQ the p-type region (1) of the junction (J1, D1) by means of a metallic contact (3) produced on at least part of the said p-type region (1), characterised in that the control method consists, in programming mode, of applying to the integrated circuit a supply voltage level higher than a nominal value, within a permissible upper limit for the integrated circuit, and applying this level to the drain and gate of the selection transistor (T1, M1), the said selection transistor (T1, M1) being produced with a channel having a length less than or equal to the minimum length of the CMOS technology under consideration, so as to bias the said selection transistor (T1, M1) in bipolar conduction mode.

2. Control method according to Claim 1, characterised in that, in programming, means of limiting the programming current are provided.

3. Control method according to Claim 1 or 2, characterised in that it consists, in read mode, of applying the supply voltage of the integrated circuit to the gate of the selection transistor (T1, M1) and to the n-type region (4, 6) of the junction (J1, D1), in order to detect a level representing the state, programmed or not, of the cell (C) on the drain of the said cell (C).

4. Control method according to Claim 1 or 2, characterised in that it consists, in read mode, of applying the supply voltage of the integrated circuit to the gate of the selection transistor (T1, M1) and the earth at the n-type region (4, 6) of the junction (J1, D1), in order to detect, at the drain of the said transistor, a level representing the state, programmed or not, of the cell (C), the said drain being biased at a voltage level lower than the direct-biased junction voltage.

5. Integrated circuit memory in CMOS technology organised in a matrix in bit lines (LB) and word lines (WL), each memory cell (C) having in series an n-type MOS selection transistor (T1, M1) and a p-n semiconductor junction (J1, D1), the source of the transistor (T1, M1) being connected to the p-type region (1) of the junction (J1, D1) by means of a metallic contact (3; produced on at least part of the said p-type region (1), the drain of the selection transistor (T1, M1) being connected to a bit line (LB), the gate of the selection transistor (T1, M1) being connected to a word line (WL) and the n-type region of the junction (J1, D1) being connected to a common n-p line, the said memory comprising control means for the said cells (C) in order to perform the steps of the method according to any one of the preceding claims.
